# DEMANDE DE BREVET EUROPEEN

(11) **EP 3 109 201 A1**
(43) Date de publication de la demande: **28.12.2016**
(21) Numéro de dépôt: 15173720.2
(22) Date de dépôt: 24.06.2015
(51) Int. Cl.: C01B 31/02

(54) **MATÉRIAU BIPHASIQUE À BASE DE SILICE ET DE NANOTUBES DE CARBONE**

(71) Demandeur: Luxembourg Institute of Science and Technology (LIST), 4362 Esch-sur-Alzette (LU)
(72) Inventeur: Didier ARL, F-57050 Metz (LU); Damien LENOBLE, B-6920 WELLIN (LU); Mouhamadou Moustapha SARR, F-67000 STRASBOURG (LU)
(74) Mandataire: Lecomte & Partners

(57) **Abrégé**

L'invention a pour objet un procédé de synthèse d'un matériau biphasé, ledit matériau biphasé comprenant au moins un substrat mésoporeux entouré de nanotubes de carbone, ledit procédé comprenant l'étape (a) de provision d'un catalyseur sur ledit au moins un substrat mésoporeux, ledit catalyseur étant configuré pour favoriser la croissance desdits nanotubes de carbone et ledit procédé comprenant l'étape (b) d'effectuer la croissance des nanotubes de carbone. Ledit procédé de synthèse est remarquable en ce que les deux étapes (a) et (b) sont effectuées en une synthèse monotope.

## Description

### Domaine technique

L'invention a trait à la synthèse d'un matériau biphasique à base de silice, en particulier de la diatomée, et de nanotubes de carbone.

### Art antérieur

Les diatomées sont des organismes aquatiques microscopiques et unicellulaires disposant d'une enveloppe siliceuse (d'épaisseur 50 nm). De formes et de tailles différentes variant entre 1 et 10 microns, les diatomées sont constituées de nano-pores, de nano-canaux auto-organisés, ce qui leur confère une grande surface spécifique de l'ordre de 30 à 200 m²/g. Cette grande surface spécifique offre la possibilité d'y faire croître une grande densité de CNTs en plus d'avoir une grande surface de contact avec la matrice.

Les diatomites sont définies comme une roche siliceuse d'origine organique.

La fabrication d'un matériau biphasé CNTs/silice de diatomées est un défi technologique à relever dans la mesure où les diatomées sont des structures de formes complexes et que la croissance de nanotubes de carbone nécessite plusieurs étapes selon la méthode de croissance choisie.

Il est supposé que l'utilisation de CNTs en remplacement du noir de carbone (carbone amorphe) dans les matériaux composites favorisera l'émergence de nouveaux matériaux avec toutes sortes de nouvelles propriétés intéressantes.

En effet, les CNTs sont connus pour posséder de meilleures propriétés par rapport au noir de carbone. L'amélioration de la résistance à l'usure et/ou la meilleure rétention de propriétés mécaniques peuvent entre autres être citées.

Les méthodes de dépôts chimiques en phase vapeur permettent de déposer des films ou des nanoparticules sur des substrats à partir de précurseurs injectés au proche du substrat en phase gazeuse. Le principe consiste à mettre sous forme gazeuse les précurseurs qui peuvent être liquides, solides ou gazeux et à les faire réagir entre eux pour former un film ou des nanostructures solides sur le substrat. L'avantage des méthodes en phase gazeuse par rapport aux méthodes en phase liquide est de pouvoir considérer tout type de substrats, y compris les substrats présentant une morphologie complexe comme les diatomées.

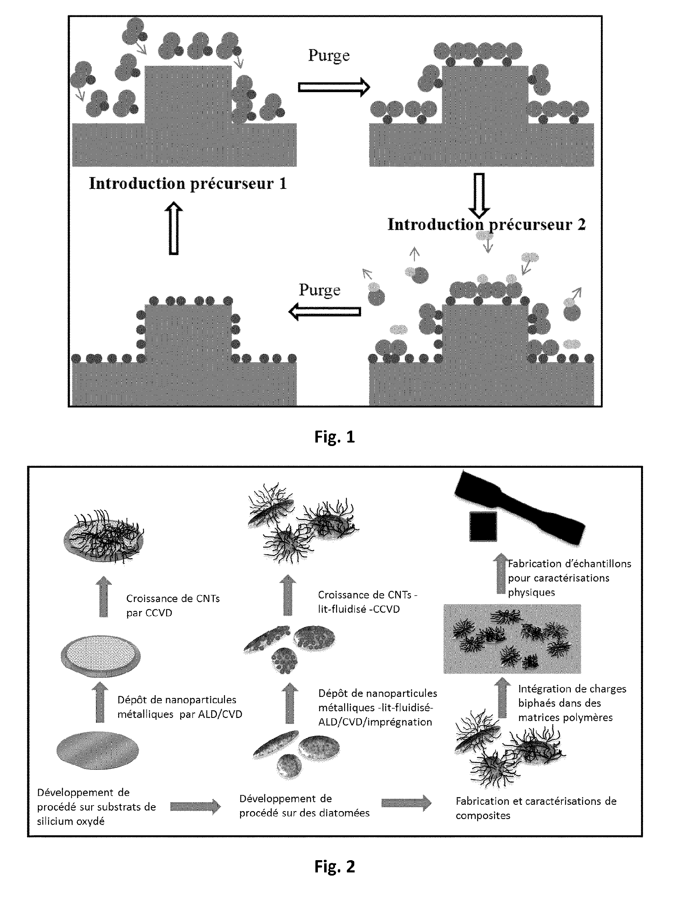

Les dépôts de couche atomique (ALD) (voir figure 1) consistent à faire réagir alternativement les précurseurs à la surfaces des substrats et présentent l'avantage d'être la technique qui aboutit aux plus grand taux de couverture (He M., et al., Nano Res., 2010, 4, 334-342*).*

Le principe de l'ALD consiste à injecter alternativement deux précurseurs séparés par un gaz de purge. Les précurseurs peuvent être solides, liquides ou gazeux mais ils seront transformés en vapeur avant d'être envoyés dans la chambre de réaction. Les étapes du procédé d'un cycle ALD sont décrites comme suit :
a. Introduction du précurseur 1 : quelle que soit sa nature (solide, liquide ou gazeuse), celui-ci doit être vaporisée depuis son contenant et transportée par un gaz vecteur inerte jusqu'à la chambre de réaction. Ce précurseur s'adsorbe sur la surface du substrat. La durée d'exposition du précurseur est un paramètre influant la structure du film puisqu'il permet de moduler la saturation de la surface par les molécules des précurseurs.
b. Purge : après l'adsorption du précurseur 1 sur le substrat, on introduit un gaz inerte pour purger et évacuer vers la pompe les molécules qui n'ont pas pu s'adsorber à la surface.
c. Introduction du précurseur 2 : la vapeur du précurseur 2 (ou réactant) est introduite dans la chambre et cette dernière est destinée à réagir avec les molécules du précurseur 1 déjà adsorbées. Le produit de la réaction forme la première couche atomique du film. Ce type de précurseur est souvent un agent réducteur, un agent oxydant, un agent nitrosant, un agent capable d'enlever un ligand du précurseur 1 ou d'apporter un élément manquant.
d. Seconde purge : une autre purge est faite dans la chambre pour évacuer tous les sous-produits de la réaction entre les deux précurseurs.

La température, la pression, et le nombre de cycles influencent également la technique ALD.

Une seconde méthode qui est utilisée pour faire croître les nanotubes de carbones est la méthode dite de dépôt chimique en phase vapeur (« CVD » en anglais). Le substrat est exposé à un ou plusieurs précurseurs en phase gazeuse, qui réagissent et/ou se décomposent à la surface du substrat pour générer le dépôt désiré.

Une troisième méthode qui peut être envisagée est la méthode de l'imprégnation en phase vapeur, qui consiste à saturer la surface du substrat par les molécules destinée à être greffée. Cette méthode est en réalité une variante de la CVD qui est utilisée lorsque le substrat devant être fonctionnalisé présente un caractère fibreux.

Il a été rapporté (Duraia E. M., et al., Vacuum, 2010, 84, 464-468) la formation de nanotubes de carbone (CNT) verticaux utilisant comme substrat la diatomite, combinant donc les avantages des CNT (propriétés électriques et optiques) et ceux de la diatomite (matériau naturel pas cher et utile dans la purification de l'eau) dans un seul matériau. La technique de dépôt chimique en phase vapeur assisté par plasma à micro-ondes a été utilisée pour la croissance des CNTs sur la diatomite. Une étape de prétraitement a été nécessaire avant l'étape de croissance des CNTs dont le méthane (CH₄) est la source principale de carbone.

### Résumé de l'invention

### Problème technique

L'invention a comme problème technique de développer une méthode simple et efficace de matériaux biphasiques composés de silice et de nanotubes de carbones. La fabrication de ce type de matériau biphasé est sensée apporter des solutions concernant l'intégration de charges telles que les CNTs dans des matrices polymères. Les nanotubes de carbone pourraient permettre de s'affranchir des noirs de carbone car disposant également d'excellentes propriétés mécaniques et thermiques en sus de leurs propriétés électriques.

### Solution technique

L'invention a pour objet un procédé de synthèse d'un matériau biphasé, ledit matériau biphasé comprenant au moins un substrat mésoporeux entouré de nanotubes de carbone, ledit procédé comprenant l'étape (a) de provision d'un catalyseur sur ledit au moins un substrat mésoporeux, ledit catalyseur étant configuré pour favoriser la croissance desdits nanotubes de carbone et ledit procédé comprenant l'étape (b) d'effectuer la croissance des nanotubes de carbone. Ledit procédé de synthèse est remarquable en ce que les deux étapes (a) et (b) sont effectuées en une synthèse monotope.

Selon un mode de réalisation préférentiel, l'étape (a) est effectuée par imprégnation du catalyseur en phase vapeur, par dépôt chimique en phase vapeur ou par dépôt de couches atomiques et/ou de particules atomiques, de préférence par imprégnation du catalyseur en phase vapeur.

Selon un mode de réalisation préférentiel, ledit catalyseur est une nanoparticule métallique fournie dans une phase gazeuse.

Selon un mode de réalisation préférentiel, ledit catalyseur est un dérivé de nickel, de préférence de Ni(acac)₂, ou un dérivé de cobalt, de préférence Co(acac)₂.

Selon un mode de réalisation préférentiel, ledit catalyseur est réduit par un dérivé d'alcool ou par de l'hydrogène gazeux.

Selon un mode de réalisation préférentiel, ledit dérivé d'alcool est un alcool primaire, de préférence le méthanol, l'éthanol et/ou propanol.

Selon un mode de réalisation préférentiel, ledit catalyseur et ledit dérivé d'alcool sont appliqués simultanément lorsque ladite étape de provision d'un catalyseur sur ledit au moins un substrat mésoporeux est réalisée par dépôt chimique en phase vapeur.

Selon un mode de réalisation préférentiel, ledit dérivé d'alcool est appliqué une fois que ledit au moins un catalyseur est déposé sur ledit au moins un substrat mésoporeux lorsque ladite étape de provision d'un catalyseur sur ledit au moins un substrat mésoporeux est réalisée par dépôt de couche atomique.

Selon un mode de réalisation préférentiel, ledit hydrogène gazeux est mélangé avec de l'azote gazeux.

Selon un mode de réalisation préférentiel, ledit mélange entre ledit hydrogène gazeux et ledit azote gazeux comprend une portion d'hydrogène gazeux par rapport à l'azote gazeux qui est comprise entre 2% et 30%, préférentiellement entre 10% et 20%.

Selon un mode réalisation préférentiel, ledit mélange entre ledit hydrogène gazeux et ledit azote gazeux comprend une portion d'hydrogène gazeux par rapport à l'azote gazeux qui est de 10%, 11%, 12%, 13%, 14%, 15%, 16%, 17%, 18%, 19%, ou 20%, préférentiellement 10% ou 20%.

Selon un mode de réalisation préférentiel, l'étape de réduction du catalyseur par l'hydrogène gazeux est effectuée pendant une durée comprise entre 2 minutes et 30 minutes, de préférence entre 5 minutes et 20 minutes, plus préférentiellement entre 10 minutes et 20 minutes, encore plus préférentiellement pendant une durée de 20 minutes.

Selon un mode de réalisation préférentiel, ledit au moins un substrat mésoporeux est composé d'un dérivé de silice, de préférence de silice de diatomées ou de silicium, plus préférentiellement de silice de diatomées.

Selon un mode de réalisation préférentiel, ledit au moins un dérivé de la silice est thermiquement oxydé à 1100°C pour fournir une couche de dioxyde de silicium de 50 nm d'épaisseur, avant ladite étape de provision d'un catalyseur sur ledit au moins un substrat mésoporeux.

Selon un mode de réalisation préférentiel, le Ni(acac)₂ est sublimé à une température comprise entre 150°C et 190°C, préférentiellement à 180°C.

Selon un mode de réalisation préférentiel, le Co(acac)₂ est sublimé à une température comprise entre 150°C et 190°C, préférentiellement à 170°C.

Selon un mode de réalisation préférentiel, ladite synthèse monotope est effectuée dans un réacteur à lit fluidisé.

Selon un mode de réalisation préférentiel, ladite étape de croissance de nanotubes de carbone comprend une étape de croissance avec de l'acétylène gazeux, ledit acétylène gazeux étant mélangé avec de l'azote gazeux ou un autre gaz inerte.

Selon un mode de réalisation préférentiel, ladite étape de croissance des nanotubes de carbone est effectuée à une pression comprise entre 2 mbar et 5 mbar, préférentiellement à 13 mbar, et à une température comprise entre 500°C et 800°C, de préférence à une température de 500°C, 550°C, 600°C, 650°C, 700°C, 750°C ou 800°C, plus préférentiellement à une température de 600°C.

Selon un mode de réalisation préférentiel, ladite étape de croissance des nanotubes est effectuée pendant une durée comprise entre 3 minutes et 60 minutes, de préférence pendant un temps de 20 minutes, 40 minutes ou 60 minutes, plus préférentiellement pendant un temps de 40 minutes ou 60 minutes, encore plus préférentiellement pendant une période de 40 minutes.

Selon un mode de réalisation préférentiel, ledit mélange entre l'acétylène gazeux et ledit azote gazeux comprend une portion d'acétylène gazeux par rapport à l'azote gazeux qui est comprise entre 2% et 30%, de préférence qui est de 10% ou 20%, plus préférentiellement qui est de 20%.

L'invention a également pour objet un matériau biphasé obtenu par le procédé de synthèse conforme à l'invention. Ledit matériau biphasé est remarquable en ce qu'il est un agent de renforcement d'un matériau composite, préférentiellement d'un matériau composite à base de polymères.

### Avantages de l'invention

L'invention est particulièrement intéressante en ce que les matériaux biphasique à base de silice, plus particulièrement de diatomée, et de nanotubes de carbone, peuvent être utilisés comme agent de renforcement dans des matériaux composites à base de polymère, préférentiellement à base d'élastomère. Le procédé décrit ici donne une façon rapide et efficace de synthétiser ce type de matériau biphasique, évitant tout problème de contamination et permettant de combiner les avantages des nanotubes de carbones avec ceux de la silice et des diatomées en particulier.

### Brève description des dessins

Figure 1 : Principe de l'ALD.
Figure 2 : Fabrication de composite renforcés par un matériau biphasé (diatomées + CNTs).
Figure 3 : Taux de croissance par cycle en fonction de t_{alcool} et du type d'alcool à 250°C avec t_{Ni} =t_{P} =2s.
Figure 4 : Profiles en profondeur XPS de films déposés en utilisant le Ni(acac)₂ et (a) propanol, (b) éthanol et (c) méthanol comme agents de réduction.
Figure 5 : Spectres XPS des niveaux de coeur de Ni 2p et C 1s des films déposés en utilisant différents alcools comme agents de réduction à 300°C et 400 s de temps de décapage.
Figure 6 : Profils en profondeur XPS de films déposés à 350°C en utilisant le Co(acac)₂ réduit par les trois alcools, le temps de pulse de Co(acac)₂ est de 3s, le temps de purge 2s, le temps de pulse des alcools, 4s et 4000 cycles.
Figure 7 : Spectres XPS des niveaux de coeur a) à la surface et à 300s de pulvérisation à l'argon du C 1s, b) du C 1s et sa déconvolution par une fonction Gaussien-Lorentzien, c) du Co 2p à la surface et à 300s de pulvérisation à l'argon des films déposés à 350°C réduits par le propanol.
Figure 8 : Procédure de croissance de nanotubes sur substrat plan.
Figure 9 : Images MEB de la morphologie des différents substrats utilisés pour la croissance de nanotubes de carbone.
Figure 10 : Images MEB des structures carbonées synthétisées à 500°C et 700°C sur des catalyseurs réalisés par ALD de Ni(acac)₂ et de méthanol à 300°C, 1000 cycles et 3000 cycles.
Figure 11 : Images MEB de la morphologie des films déposés dans différentes conditions utilisés pour la croissance de nanotubes de carbone.
Figure 12 : Images MET de l'échantillon synthétisé à 500°C sur des catalyseurs réalisés par CVD.
Figure 13 : Images MET de l'échantillon synthétisé à 700°C sur des catalyseurs réalisés par CVD.
Figure 14 : Images MEB de nanotubes de carbone synthétisés à différentes températures après imprégnation en phase vapeur.
Figure 15 : Images MET de l'échantillon synthétisé à 700°C sur des catalyseurs réalisés par imprégnation.
Figure 16 : Images MEB des structures carbonées synthétisées à 500°C et 700°C sur des catalyseurs réalisés par ALD.
Figure 17 : Images MET des structures carbonées synthétisées à 500°C et 700°C sur des catalyseurs réalisés par ALD.
Figure 18 : Images MEB de nanotubes de carbone synthétisés sur des échantillons réalisés par ALD Co, 300°C, 1000 cycles et 4000 cycles.
Figure 19 : Images MEB de nanotubes de carbone synthétisés à différents temps de croissance.
Figure 20 : Images MEB de nanotubes de carbone synthétisés à différents temps de réduction.
Figure 21 : Images MEB de nanotubes de carbones synthétisés à différentes concentration d'acétylène.
Figure 22 : Images MEB de la morphologie des dépôts de nanoparticules de carbure de cobalt en fonction de la température du procédé ALD.
Figure 23 : morphologie des dépôts et distribution en taille des grains de cobalt en fonction du nombre de cycles de dépôt ALD.
Figure 24 : Images MET de nanotubes sur diatomées synthétisés à différentes températures.
Figure 25 : Images MET de nanotubes sur diatomées synthétisés à différents temps de croissance.
Figure 26 : Images MET de nanotubes sur diatomées synthétisés à différentes concentrations d'acétylène.
Figure 27 : Images MET de nanotubes sur diatomées synthétisés à différents temps de réduction.
Figure 28 : Images MEB de nanotubes sur diatomées synthétisés à 600°C, 45 minutes, 20% de concentration en acétylène et 20 minutes de réduction à l'hydrogène.
Figure 29 : Analyses thermogravimétriques sous air de nanotubes sur diatomées synthétisés à 600°C, 45 minutes, 20% de concentration acétylène et 20 minutes de réduction.

### Description d'un mode de réalisation

Comme indiqué sur la figure 2, dans un premier temps, le procédé de croissance de CNTs sur substrats de silicium oxydé a été développé. Ce procédé comprend le dépôt de nanoparticules de Ni et de Co par ALD/ CVD/ imprégnation suivi d'une croissance de nanotubes par CCVD. Ce procédé est ensuite transféré sur des diatomées (substrat 3D) à travers un lit-fluidisé. L'intégration du matériau biphasé synthétisé dans des matrices polymères se fera en utilisant une extrudeuse. La fabrication d'éprouvettes pour les caractérisations physiques se fait à l'aide d'une mouleuse par injection et d'une presse hydraulique.

La croissance de nanotubes de carbone requiert un choix pertinent de catalyseurs et de leurs techniques de préparation. Le choix du type de catalyseur est contraint par l'application visée. Le Ni et Co ont été sélectionnés du fait qu'ils n'ont pas a priori un impact négatif dans le vieillissement des pneus contrairement au Fe. Les diatomées qui sont utilisées comme substrat mésoporeux de diverses formes complexes (poudres), toutes les techniques de dépôts ne permettent donc pas de déposer des nanoparticules sur leur surface. Pour cela la technique de dépôt par couches atomiques (ALD a été choisie): elle est la plus adéquate pour déposer des matériaux sur des substrats complexes. L'imprégnation en phase vapeur a aussi été expérimentée.

Du méthanol, de l'éthanol et du propanol pour la réduction de précurseurs métal-organiques tels que le nickel acetylacétonate et le cobalt acetylacétonate dans les procédés ALD sont utilisés. C'est la première fois que les alcools sont employés en ALD comme agents réducteurs pour déposer des couches de Ni et Co (et leurs dérivés tels que les carbures). Un dispositif TFS200 de Beneq comme machine pour les dépôts ALD a été utilisé.

Dépôt sur substrats plans.

### Substrats.

Les substrats plans utilisés sont constitués d'une plaquette de silicium recouverte d'une couche de 50 nm d'oxyde de silicium. Cette couche d'oxyde modélise bien la surface des diatomées et évite la formation d'alliages tels que les siliciures entre le silicium et les métaux de transition tels que Ni et Co. Cette couche fait office de barrière à la diffusion de ces métaux dans le silicium. Sa croissance se fait par RTCVD (Rapid Thermal Chemical Vapour Deposition) à 1000°C sur un substrat de silicium orienté selon le plan (100).

### Nettoyage.

Les échantillons (silicium oxydé) sont dans un premier temps trempés dans de l'acétone sous ultrasons pendant 10 minutes suivi d'un rinçage à l'eau désionisée. Les échantillons sont plongés ensuite dans de l'éthanol sous ultrasons pendant 10 minutes et sont rincés ensuite avec de l'eau désionisée. Ce nettoyage permet d'éliminer les contaminants organiques et de former suffisamment de groupements hydroxyles -OH en surface de la fine couche de silice pour réagir avec les précurseurs lors des réactions provoquées par la méthode ALD.

### Précurseurs.

Des précurseurs organométalliques sont utilisés : le nickel acétylacétonate et le cobalt acétylacétonate, qui sont des molécules stables et peu coûteuses, peu toxiques et faciles à conserver.

Le nickel et le cobalt acétylacétonate sont achetés dans le commerce (Sigma-Aldrich) sous forme de poudres.

Les poudres seront ensuite chargées dans une canne qui sera introduite dans la source solide chaude. Pour évaporer les précurseurs, cette source est chauffée à 170°C pour le nickel et à 180°C pour le cobalt. Ces températures permettent d'évaporer une grande quantité de matière sans la décomposer. La vapeur sera transportée jusqu'à la chambre de réaction par un flux d'azote.

### Réactants.

Du méthanol, de l'éthanol et du propanol sont utilisés ici comme des réactants pour la réduction des vapeurs de nickel acétylacétonate et de cobalt acétylacetonate déjà adsorbées à la surface du substrat. Ces alcools de pureté 99% sont achetés dans le commerce (Sigma-Aldrich).

La déshydrogénation des alcools est un procédé qui a été mis en place pour la production d'aldéhydes et de cétones. La capacité des alcools à subir la déshydrogénation dépend fortement de leur structure et de la température. Ce procédé est aussi catalysé par les métaux de transition ou par des complexes liés aux métaux de transition.

Le mécanisme de réaction est décrit comme suit : les groupements -OH à la surface de l'échantillon sont partiellement ionisés. L'adsorption de M(acac)₂ à la surface de l'oxyde de silicium est rendue possible par le fait que ces groupements -OH aient accepté le ligand axial du M(II). Ceci entraine une coordination du métal avec un ligand acétylacétonate à la surface et une libération d'une molécule d'acétylacétone. La formation d'une molécule d'acétylacétone est due aux fortes interactions entre les protons des groupements -OH de surface et le système des électrons des ligands acétylacétonate]. Le M(acac) adsorbé est ensuite réduit par des atomes d'hydrogène suite à une interaction avec l'alcool.

Pour chaque procédé ALD, un protocole avec les paramètres de dépôt sous forme d'un programme informatique séquentiel est utilisé. Ce programme commande l'ouverture des vannes pour chaque pulse et purge, les températures et durées de chauffage de la chambre de réaction et des sources chaudes, les flux de gaz porteurs, le nombre de cycles et les temps de pulse pour chaque précurseur. Pour les dépôts sur substrat plan, la température de dépôt a été variée entre 200 et 390°C. Les temps de pulse et de purge allaient de 0,1 à 4s et le choix final dépendait du taux de croissance et de la morphologie visés pour les films. Les flux de gaz vecteurs sont fixés à 300 sccm, suffisants pour transporter les précurseurs jusqu'au réacteur. Le nombre de cycles ALD a été varié de 100 à 4000 en fonction de l'épaisseur de film ou des morphologies à obtenir.

### Dépôt sur diatomées.

Une procédure analogue à celle sur substrat plan est utilisée sauf que les diatomées sont sous formes de poudre, ce qui implique l'utilisation d'un lit fluidisé interne. Les procédés de dépôt sur poudres utilisent les mêmes précurseurs que les dépôts sur substrats plans. Toutefois les paramètres typiques du procédé de dépôt sur diatomées demandent à être optimisés.

### Croissance de nanotubes de carbone.

Comme pour la préparation des particules de catalyseur, la croissance de CNTs est dans un premier temps réalisée sur substrats plan (silicium oxydé) afin de déterminer la valeur optimale des paramètres de croissance. Puis dans un second temps, cette croissance est réalisée sur les diatomées en configuration 3D. La méthode de dépôt chimique catalytique (CCVD) est utilisée dans un appareil MC200 fabriqué par Annealsys pour traiter les substrats plans. En revanche un réacteur en lit-fluidisé est utilisé pour la croissance de CNTs sur diatomées.

### Croissance de CNTs sur substrat plan.

La machine Annealsys MC200 est un réacteur MOCVD (de l'anglais Metal Oxide Chemical Vapour Deposition) à température de parois contrôlée. La configuration de la machine MC200 est la suivante :

Réacteur en inox avec contrôle de température des parois et porte-substrat chauffant pour des plaquettes allant en diamètre jusque 200 mm.

Porte-substrat chauffant et plasma RF avec une température maximale de 850°C.

Un système de vaporisation Kemstream VapBox 4000 avec 4 têtes d'injection de précurseurs liquides et 6 lignes de gaz de procédé.

### Croissance de CNTs sur diatomées.

Les diatomées sont sous forme de poudres de particules comprises entre 1 et 10 microns de diamètre. La croissance de nanotubes de carbone sur ces dernières ne peut donc pas se faire dans une configuration planaire mais dans un réacteur à lit fluidisé.

### Technique de caractérisation.

### Microscope Electronique à Balayage (MEB).

Au cours de ce travail, les observations MEB ont été réalisées avec un microscope « Helios Nanolab 650 ». Les échantillons de couches minces ont été directement déposés sur un support en aluminium fixé par un ruban adhésif en carbone double faces. La poudre de diatomées sur laquelle sont formés les nanotubes est aussi directement déposée sur le ruban adhésif pour être analysée. Les images MEB montrées dans cette thèse ont été enregistrées avec une tension d'accélération de 2 kV et une intensité de 25 mA.

Le MEB est parfaitement adapté à l'observation des morphologies des couches minces, des particules de catalyseur mais aussi des nanotubes de carbone. Cette technique donne des renseignements sur la densité, la taille des nanoparticules et des nanotubes de carbone, et permet d'imager des structures de taille allant jusqu'à 10 nm. Le MEB renseigne aussi sur la dispersion des nanotubes dans la matrice polymère, une information cruciale pour la compréhension des propriétés physiques du composite.

### Microscope Electronique à Transmission (MET).

De par sa haute résolution spatiale, le MET permet d'accéder à des informations de l'ordre atomique. Il permet de distinguer les nanotubes monoparoi ou multiparois et de voir les défauts qui sont sur les tubes. Avec le MET, il est possible des distinguer les structures suivantes : nanotubes, fibres, structure en bambou...Cette imagerie permet également d'évaluer comment les nanotubes sont dispersés dans le PMMA. Les analyses MET ont été faites avec un 'LEO 922 OMEGA' équipé d'un pistolet à émission de champ avec une tension d'accélération pouvant aller jusqu'à 200 kV, de détecteurs EELS (spectromètre de pertes d'énergie d'électrons), Rayons X, SE (électron secondaire), et BSE (électrons retro-diffusés). La résolution de l'instrument est de 0.29 nm.

Les échantillons de composite (PMMA+ biphasés) ont été découpés en fines tranches d'épaisseur variant entre 70-100 nm par un microtome. Les échantillons sous forme de poudres ont été directement déposés sur la grille TEM.

### Spectroscope de photoélectrons X (XPS).

L'XPS est une technique d'analyse chimique de surface avec laquelle l'échantillon est irradié par des rayons X monochromatiques. Ces derniers, par effet photoélectrique, provoquent l'ionisation des atomes. Celle-ci permet d'accéder à des informations telles que la composition chimique des matériaux (couches minces). L'XPS est parfaitement adaptée pour connaître la composition chimique des nanoparticules de catalyseur et des films minces métalliques qui sont utilisés pour la catalyse de la croissance de nanotubes de carbone. Les analyses ont été faites avec un dispositif Kratos axis ultra DLD équipé d'un tube à rayon X (Al Kα d'énergie hv= 1486.6 eV) avec une puissance de 150 W; analyseur d'énergie constitué de deux électrodes hémisphériques ; un système d'acquisition et de traitement de données permettant l'acquisition spectres à haute résolution (énergie de passage 40 eV) et de spectres globaux (énergie de passage 160 eV). L'instrument dispose d'une résolution spatiale de 10 µm (spectroscopie) et 3 µm (imagerie) ; la limite de sensibilité est de 0.5. Les énergies de liaisons sont calibrées sur l'énergie de liaison du carbone 1s.

La stabilité thermique des matériaux composites a été mesurée à travers leur comportement sous l'effet de la chaleur. L'analyse thermogravimétrique (TGA) est souvent utilisée pour déterminer les caractéristiques des matériaux qui sont liées à leur perte de masse. Cette perte de masse est due à la décomposition, à l'oxydation...des composants du matériau sous l'effet de la température. La TGA a été utilisée pour investiguer la stabilité thermique des composites à travers leur perte de masse. L'appareil utilisé est un NETZSCH-STA 409 PC, avec un flux d'air de 100 cm³.min⁻¹ dans un creuset en aluminium contenant 20-25 mg de l'échantillon. Les mesures ont été faites dans des conditions dynamiques avec une rampe de température de 10°C.min⁻¹.

Afin de déterminer les conditions optimales de croissance sur les diatomées d'une haute densité superficielle de nanotubes multi-parois avec aussi peu de défauts que possible, le procédé a été développé dans un premier temps sur des substrats plans. Un substrat de silicium oxydé comportant en surface une couche de 50 nm d'oxyde de silicium SiO₂ a été sélectionné afin de reproduire la nature chimique de la coque des diatomées qui est constituée d'environ 50 nm d'oxyde de silicium.

La préparation des catalyseurs de nickel et de cobalt est décrite. L'ALD de Ni(acac)₂ et de Co(acac)₂ réduits par des alcools est utilisée sur des substrats d'oxyde de silicium. Ce procédé a été développé auparavant en CVD [113] mais a été développé pour la première fois en ALD. La croissance de nanotubes de carbone par CVD sur des nanoparticules catalytiques préparées par ALD, CVD et imprégnation en phase vapeur est ensuite présentée.

### Préparation des catalyseurs.

La croissance de nanotubes de carbone est catalysée par des nanoparticules de cobalt et de nickel préparées par la technique ALD.

### Dépôt de nickel par ALD.

Dans le but de caractériser leur composition chimique, leur structure cristalline et leur morphologie, des films d'épaisseur allant de 10 à 100 nm ont été déposés. Du nickel acétylacetonate comme précurseur et des alcools (méthanol, éthanol et propanol) comme agents de réduction ont été utilisés. Les films ont été déposés sur du silicium oxydé thermiquement à 1100°C, avec une épaisseur de 50 nm de SiO₂ suffisante pour empêcher toute diffusion du nickel dans le substrat. Le Ni(acac)₂ est sous forme de poudre et a été sublimé à 180°C ; quant aux alcools ils ont été évaporés à température ambiante. La purge du réacteur est assurée par un flux d'azote continu de 300 sccm. Un cycle ALD comprend un pulse de Ni(acac)₂ (temps de pulse t_{Ni}) et un pulse d'alcool (temps de pulse t_{alcool}) séparés par une purge du réacteur (temps de purge t_{P}). Le temps de purge est fixé à 2s et le temps de pulse de Ni(acac)₂ et d'alcools varient entre 0.1 et 4s. La température de dépôt varie entre 200 et 300°C.

### Croissance des films.

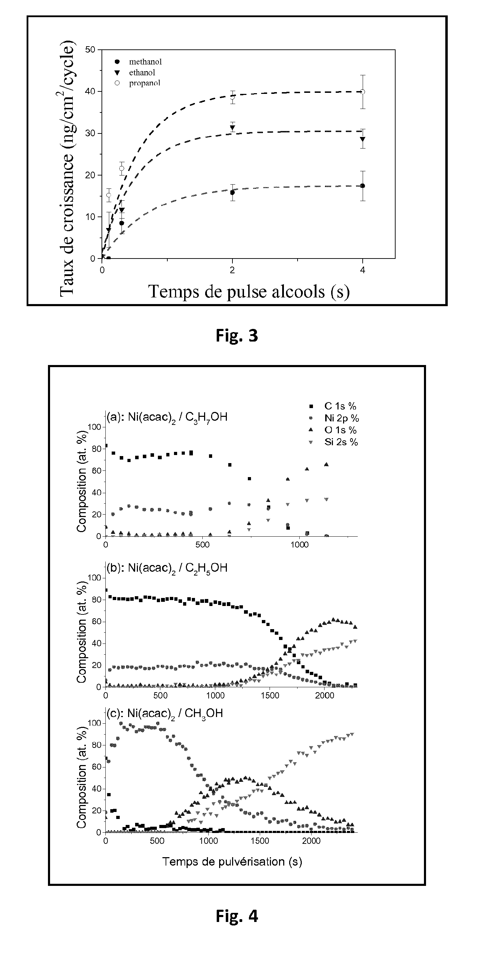

La figure 3 montre l'augmentation du taux de croissance des films (défini ici en ng/cm²/cycle) en fonction du temps d'injection d'alcools (t_{alcool}) pour les trois alcools de longueur de chaîne alkyle croissante. Cette augmentation a été déjà observée par Premkumar et ses collaborateurs dans le cadre d'un procédé CVD utilisant le Co(acac)₂ comme précurseur (Premkumar P. A., et al, Chem. Vap. Depos., 2007, 13, 219-226). Ceci est attribué à la dissociation incomplète de l'alcool durant le procédé conduisant à une incorporation du carbone dans le film et par conséquent à l'augmentation de la masse du film. Par ailleurs la réduction du nickel acétylacetonate adsorbé à la surface par des alcools se fait via les atomes d'hydrogène provenant des groupements alcools. La réactivité des alcools primaires a été étudiée en fonction de la longueur de leur chaîne : il a été démontré que le propanol fournit préférentiellement un proton comparativement aux autres alcools (Premkumar P. A., et a/., Chem. Mater., 2007, 19, 6206-6211). Ceci pourrait aussi expliquer le fait que le taux de croissance obtenu avec le propanol est supérieur à celui obtenu avec l'éthanol, lui-même supérieur à celui obtenu avec le méthanol.

### Composition chimique et structures cristallines des films.

L'analyse chimique des films a été conduite en utilisant l'XPS, associée à un bombardement ionique afin de sonder la composition en épaisseur. Ainsi des quantités élevées de carbone (70-80%) ont été détectées à la surface et en profondeur dans les films synthétisés avec l'éthanol et le propanol comme agents de réduction (Figures 4a et 4b). Par contre en utilisant le méthanol, des films de nickel de pureté avoisinant 95% ont été obtenus, et le carbone est principalement présent à la surface du film sous forme de contaminations carbonées (cette contamination est usuelle en XPS et provient des molécules atmosphériques qui peuvent s'adsorber à la surface des échantillons lors de leur manipulation) (Figure 4c).

L'augmentation de la quantité de carbone est corrélée avec celle du taux de croissance obtenu en utilisant l'éthanol et le propanol par rapport au méthanol.

Il a été montré que la déshydrogénation des alcools primaires fournit de l'hydrogène, du CO, du CO₂ des aldéhydes et d'autres fragments provenant de leur décomposition. L'utilisation du méthanol qui n'a qu'un seul atome de carbone dans sa structure est donc favorable pour réduire la contamination du film en carbone et permet alors d'obtenir la croissance d'un film métallique de nickel.

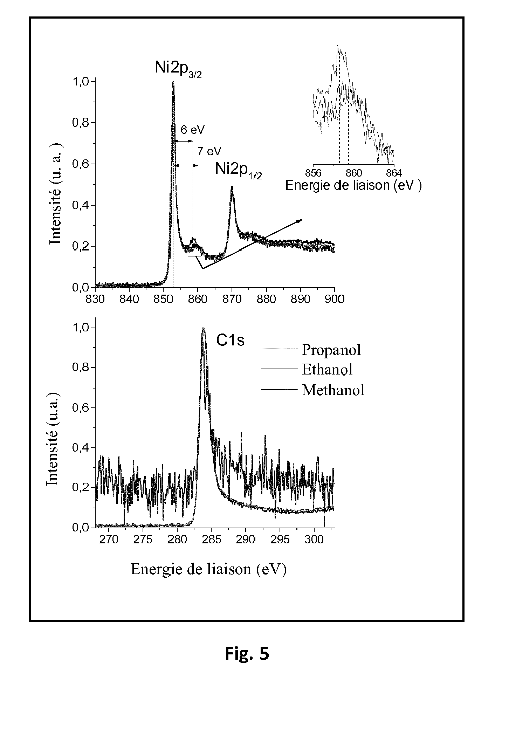

Le carbone est le principal élément présent à la surface du film formé avec le méthanol comme agent réducteur mais ensuite dans le coeur du film, le nickel devient l'élément majoritaire jusqu'à ce que l'on atteigne la couche de silice. En revanche, pour les films déposés en utilisant l'éthanol et le propanol, le carbone est l'élément dominant en surface et dans le film, jusqu'à la couche de silice. Les spectres XPS des niveaux de coeur du carbone et du nickel sont montrés sur la figure 5. La structure fine du pic du niveau de coeur du Ni2p montre que cet élément est sous forme de nickel réduit (métallique) pour tous les films. L'énergie de liaison du Ni 2p3/2 dans sa phase métallique a été reportée à 852.8 eV et est différente de celle de ses phases oxydes (854,6 eV pour NiO ; 855,7 eV pour Ni₂O₃ et 856,45 eV pour le Ni(OH)₂).

Le spectre XPS du Ni 2p3/2 dans sa phase métallique possède un pic satellite à +6 eV qui a été attribué aux pertes énergétiques des plasmons et aux transitions inter-bandes. Ce pic satellite est retrouvé sur le spectre Ni 2p du film déposé en utilisant le méthanol comme agent de réduction (Figure 5 en insert). Avec l'éthanol ou le propanol, les pics satellites sont décalés de 1 eV vers les grandes énergies de liaison. Cet effet a également été observé sur un composite de carbure de nickel et de carbone déposé par un procédé de pulvérisation. Les auteurs l'ont attribué à la présence de carbone dans la phase cristalline du nickel modifiant l'écrantage électrostatique des électrons 2p (Abrasonis G., et al., X-Ray spectroscopic and magnetic investigation of C, 2008, 112, 12628-12367). En se basant sur ces résultats, il est conclu que l'utilisation du propanol ou de l'éthanol mène à la formation de carbure de nickel mais l'utilisation du méthanol conduit à la formation du nickel métallique.

### ALD du cobalt.

La structure chimique et la morphologie des films déposés utilisant le cobalt acétylacétonate réduits par le méthanol, l'éthanol et le propanol sont présentées.

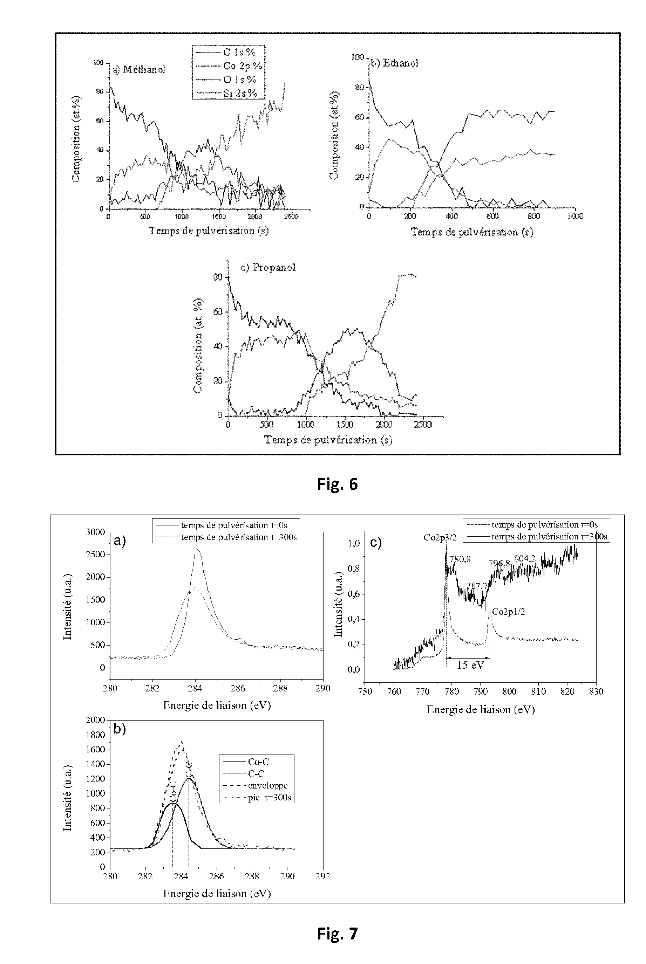

La figure 6 montre les analyses XPS de films déposés à partir du Co(acac)₂ et des trois alcools comme agents de réduction. Contrairement aux films de nickel, le carbone est présent dans tous les films avec une concentration supérieure à 50%. La concentration de cobalt quant à elle croît en fonction de l'alcool utilisé : 25% avec le méthanol, 40% avec l'éthanol et 50% avec le propanol. Aucun des alcools utilisés ne réduit complètement le Co(acac)₂ jusqu'à l'obtention d'un film purement métallique. Les films déposés avec le propanol ont été sélectionnés pour étudier la structure cristalline des dépôts les plus épais.

La figure 7 montre les spectres C 1s et Co 2p des films déposés à 350°C avant et après bombardement ionique de la surface. L'intensité du pic de carbone C 1s à la surface du film (temps de bombardement 0s) est plus élevée que celle dans le film (temps de bombardement 300s) à cause de la contamination surfacique à l'air ambiant. Le maximum et la forme du pic sont respectivement décalés et élargis après 300s de bombardement. En faisant une décomposition spectrale en utilisant une fonction mixte Gaussienne-Lorentzienne, la présence de deux contributions à 284.4 et 283.5 eV est démontrée (Figure 7b). Celles-ci correspondent respectivement aux liaisons C-C et C-Co. Ceci indique qu'une fraction du carbone contenu dans le film est liée avec le cobalt pour former une phase de type carbure. Les énergies de liaison du Co 2p3/2 et Co 2p1/2 (Figure 7c) après 300s de bombardement sont mesurées à 778.4 et 793.4 eV et correspondent à la phase métallique du cobalt. En plus de la phase métallique, deux épaulements sont mesurés à 780.8 et 796.8 eV associés à leur satellite respectif à 787.7 et 804.2 eV et correspondent à une phase d'oxyde de cobalt.

Il a été démontré que l'ALD du Ni(acac)₂ réduit par le méthanol peut aboutir à une phase de Ni métallique et de carbure de Ni quand il est réduit par l'éthanol et le propanol. La réaction du Co(acac)₂ avec les trois alcools produit systématiquement du carbure de cobalt, y compris avec le méthanol. Cette phase carbure de cobalt n'est cependant pas rédhibitoire quant à son utilisation comme catalyseur de croissance de nanotubes de carbone. Enfin, le procédé de croissance de CNTs utilise une étape de réduction à l'hydrogène préliminaire à la croissance permettant l'activation des catalyseurs métalliques ou carbonés.

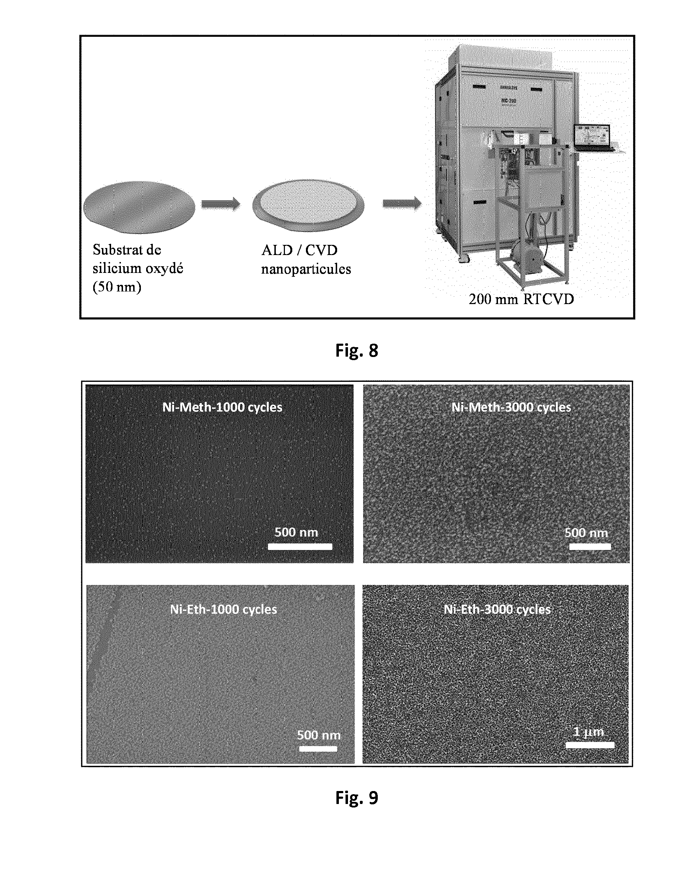

La figure 8 montre la procédure de croissance de nanotubes de carbone sur un substrat plan.

### Préparation des particules catalytiques de nickel

Des couches de nickel déposés à partir du Ni(acac)₂ réduit par le méthanol et des couches de carbure de Ni à partir du Ni(acac)₂ réduit par l'éthanol ont été utilisées. Pour chaque type, des conditions de non saturation pour aboutir à des nanoparticules bien séparées à la surface du substrat et des conditions de saturation pour déposer un film qui couvre bien la surface du substrat ont été utilisées. Pour les conditions de non saturation, les paramètres d'utilisation sont les suivants : 1s de temps de pulse Ni(acac)₂, 1s de temps de pulse de l'alcool, 2s de purge et 1000 cycles à 300°C. Pour les conditions de saturation, les paramètres d'utilisation sont les suivants : 2s de temps de pulse Ni(acac)₂, 2s de temps de pulse des alcools, 2s de purge et 3000 cycles (∼30nm pour l'éthanol, -15 nm pour le méthanol). La figure 9 montre les différentes morphologies des dépôts en fonction des paramètres de saturation. Le Ni-Meth 1000 cycles montre de plus petites particules comparé au Ni-Eth-1000 cycles, les dépôts de nickel à partir du Ni(acac)₂ réduit par le méthanol disposent de plus faible taux de croissance. L'épaisseur du film Ni-Eth-3000 cycles est de ce fait plus élevée que celle du Ni-Meth-3000 cycles.

### Croissance de nanotube catalysée par le nickel.

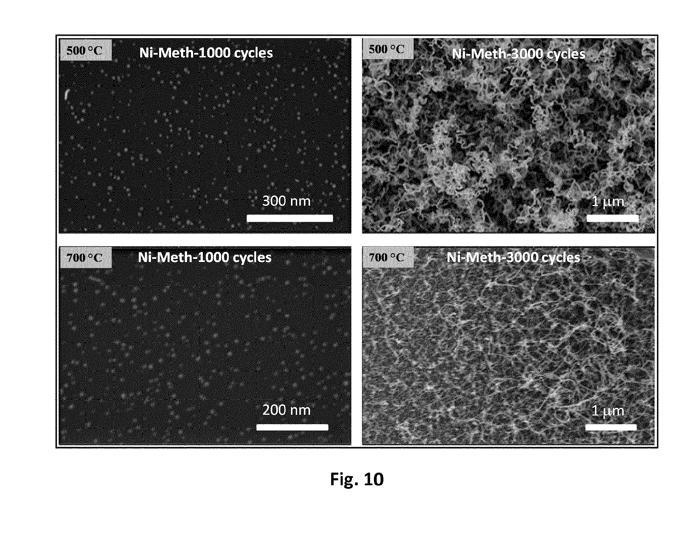

La figure 10 montre les clichés MEB des structures carbonées synthétisées à 500 et 700°C, 10 minutes réduction à l'hydrogène de concentration (H₂ : N₂) = 10 : 90. Le temps de croissance est de 10 minutes, la concentration d'acétylène (C₂H₂ : N₂) = 10 : 90. La pression dans la chambre de réaction est de 13 mbar. La croissance a été faite sur des nanoparticules de nickel déposées par ALD à 1000 et 3000 cycles.

Les essais de synthèse de nanotubes faits sur les particules déposées à 1000 cycles à 500 et 700°C n'ont pas été fructueux. Sur les échantillons déposés à 3000 cycles, des structures tortueuses ont été obtenues comme précédemment à 500°C. Par contre à 700°C, des nanotubes ont été obtenus mais avec une densité superficielle faible comparée aux tapis de nanotubes qui sont obtenus avec le cobalt.

Il a été démontré que l'ALD du Ni(acac)₂ et de l'éthanol donnait du carbure de nickel. En utilisant les mêmes conditions que précédemment, il n'y pas eu de croissance sur les échantillons déposés à 1000 cycles ALD à 700°C et quelques structures (fibres ou tubes) bien dispersés à 500°C. Pour les échantillons déposés à 3000 cycles, quelques structures (certainement des fibres) à la surface ont été observées. Par contre à 700°C, il n'y pas de croissance à part quelques longues structures à la surface.

### Préparation des particules catalytique de cobalt.

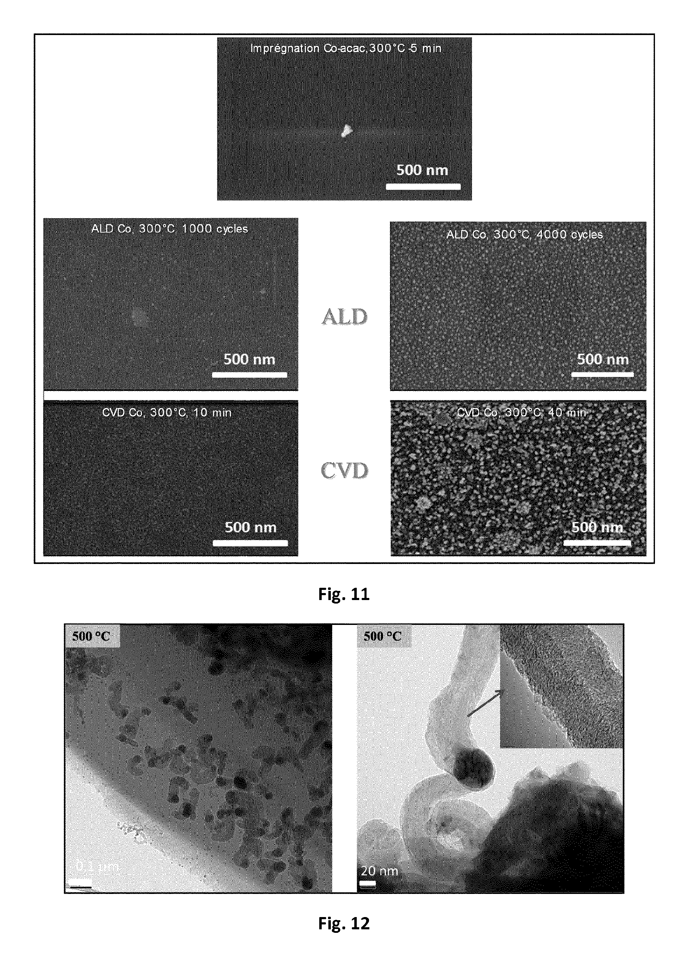

La figure 11 montre différents types de films de cobalt déposés par trois procédés différents : la CVD, l'ALD et l'imprégnation par phase vapeur. Les dépôts par CVD ont été faits à partir d'une solution de Co(acac)₂ et de l'éthanol. La poudre de Co(acac)₂ est dissoute dans de l'éthanol pour faire une solution à 5 mmol.L⁻¹. Cette solution est ainsi injectée durant 10 ou 40 min sur un substrat d'oxyde de silicium chauffé à 300°C. Les dépôts ALD ont été réalisés en faisant réagir du Co(acac)₂ et de l'éthanol à 1s de temps d'injection de Co(acac)₂, 2s de temps d'injection d'éthanol, 2s de temps de purge. 1000 cycles et 4000 cycles ont été utilisés. L'imprégnation en phase vapeur consiste à injecter pendant 150s la vapeur de Co(acac)₂ sublimé à 155°C.

Comme attendu, dans le cas de l'imprégnation, aucune nanoparticule n'est observée en MEB. En revanche la figure 11 montre la présence de telles nanoparticules pour l'échantillon ALD fait à 1000 cycles (4 à 8 nm de diamètre en moyenne), et celui fait à 4000 cycles (entre 6-8 nm de diamètre moyen). Ces valeurs sont extraites à partir des clichés MEB par le logiciel image-J. Concernant les échantillons déposés durant 10 et de 40 minutes par CVD une nette différence de morphologie a été remarquée. Après 10 min, une distribution homogène de nanoparticules (de diamètre moyen 2 à 4 nm) a été observée alors que 40 minutes de dépôt conduit à la coalescence des nanoparticules préalablement formées et à la formation d'agrégats.

### Croissance de nanotube sur les particules déposées par CVD.

La croissance de nanotubes de carbone a été faite en utilisant d'abord une étape de réduction à l'hydrogène de 10 minutes de concentration (H₂ : N₂) = 10 : 90 (rapport de pression partielle), suivie d'une étape de croissance utilisant l'acétylène comme source de carbone. Le temps de croissance est de 10 minutes, la concentration d'acétylène (C₂H₂ : N₂) = 10 : 90. La pression totale dans la chambre de réaction est de 13 mbar. La température de croissance est variée de 500 à 800°C.

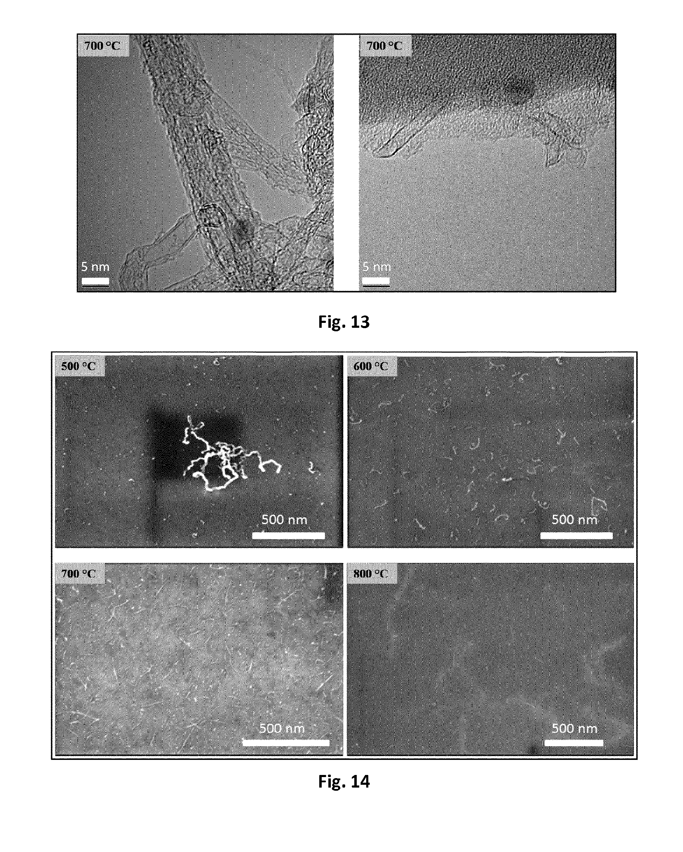

Les figures 12 et 13 montrent les clichés MET des échantillons synthétisés à 500°C et 700°C, respectivement. La figure 12 révèle des structures de type fibre de carbone de gros diamètre (∼ 80 nm) et de longueur typique ∼150nm. A 500°C, la nanoparticule de Co (clairement observée sur le cliché 18 panel gauche) catalyse une croissance « tip-growtH » de fibres de carbone. Le régime de croissance de CNTs requiert des températures minimales de l'ordre de 700°C comme confirmés par les photographies de la figure 13. Pour cette température, les structures caractéristiques de nanotubes de carbone mono et double parois sont mises en évidence. Leur diamètre varie entre 1 et 3 nm avec quelques défauts structurels notamment observés sur les nanotubes à double parois. Il est remarquable de noter que le régime de croissance est significativement modifiée avec la température compte tenu du passage d'un mode « tip-growth » à 500°C pour les fibres de carbone à un mode « bottom-growth » à 700°C pour les nanotubes. En effet, pour ces derniers, aucune particule n'est observée aux extrémités libres des nanotubes.

Ces observations confirment les précédentes analyses statistiques et soulignent la nécessité de travailler à des températures minimales de 700°C lorsque des catalyseurs de Co synthétisés par CVD sont usités.

Croissance de nanotube sur les particules déposées par imprégnation en phase vapeur.

La figure 14 montre les images MEB de nanotubes synthétisés à différentes températures sur des substrats imprégnés de vapeur de Co(acac)₂ sublimé à 170°C. La pression dans la chambre de réaction est de 13 mbar. La température est variée de 500 à 800°C.

A 500°C, quasiment aucune croissance n'est observée, seulement de très petites structures à quelques endroits de l'échantillon ainsi qu'une structure épaisse (>30nm) et tortueuse sont présentes. A 600°C, il y a une distribution plus dense de petites structures qui peuvent être associées soit à des nanofibres, soit à des nanotubes tortueux. A 700°C, des structures plus fines, de forte densité et bien dispersées sont obtenues. Des structures similaires à 800°C sont observées mais avec une densité beaucoup plus faible qu'à 700°C.

Il est donc conclu qu'à 500 et 600°C, l'énergie d'activation de l'activité de catalyse n'a pas été atteinte.

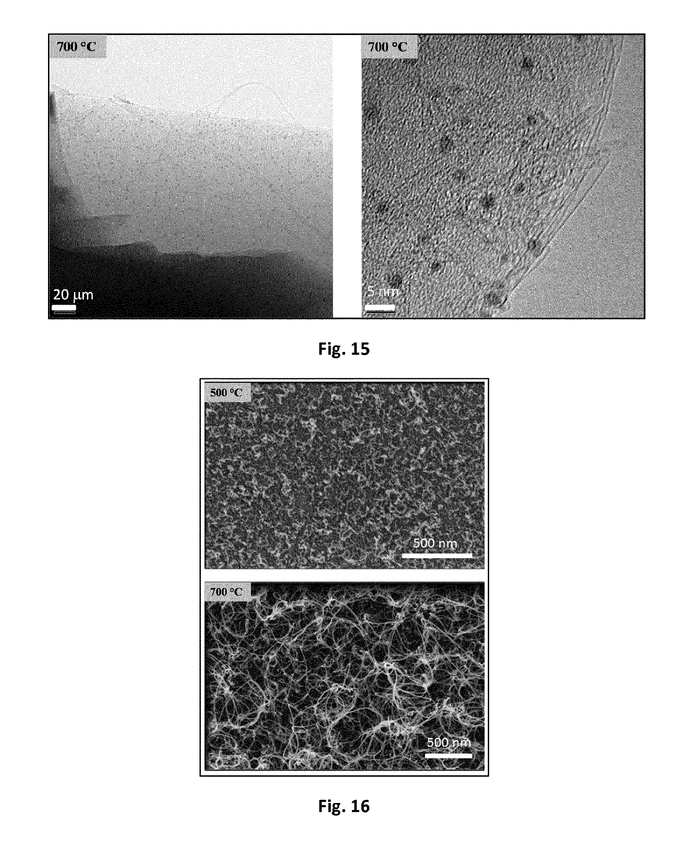

La figure 15 montre la morphologie des nanotubes obtenus à 700°C. La présence de faisceaux de nanotubes mono-paroi qui semblent bien cristallisés et sans trop de particules ou de dépôts carbonés amorphes ou d'oignons est observée.

### Croissance de nanotube sur les particules déposées par ALD.

La figure 16 montre les images MEB de nanotubes de carbone synthétisés à 500 et 700°C. Comme précédemment, à 500°C, la présence de structures fibreuses est soupçonnée. Par contre à 700°C, un tapis dense de nanotubes qui couvrent toute la surface de l'échantillon a été obtenu.

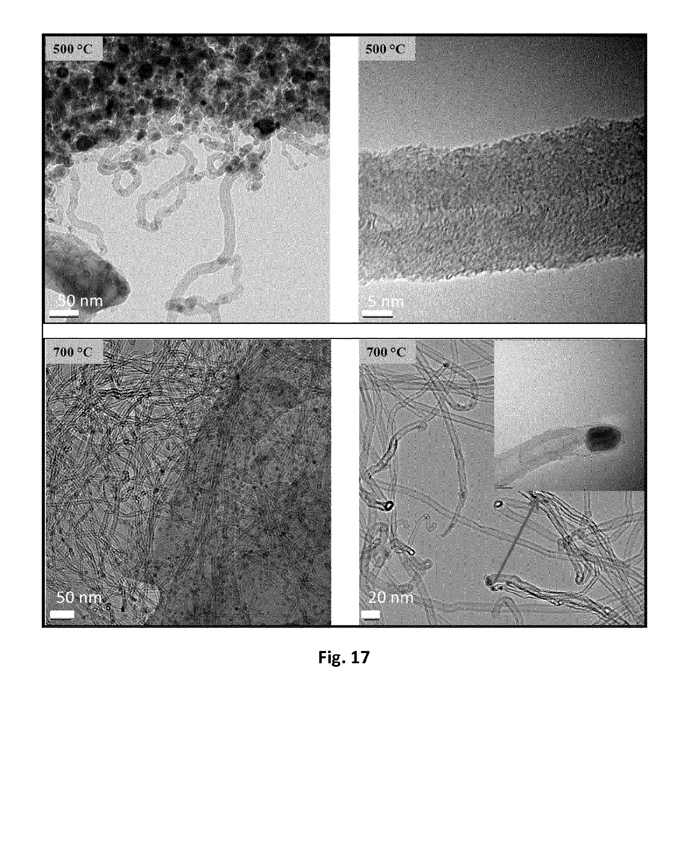

Les images MET présentées à la figure 17 confirment les structures fibreuses soupçonnées sur l'échantillon synthétisé à 500°C. A 700°C, le tapis de nanotubes correspond à des CNTs multi-parois avec quelques défauts sur les parois extérieures et de diamètre compris entre 15 et 20 nm. Le mode de croissance est de type « top-grovvth ».

Pour résumer, un mélange de nanotubes mono et double-parois à partir de 600°C est obtenu avec les échantillons CVD. La croissance de nanotubes de carbone sur les échantillons réalisés par imprégnation aboutit à des fagots de tubes mono-paroi et quelques tubes double parois. L'échantillon réalisé par ALD 4000 cycles (de taille moyenne des particules autour de 8 nm) quant à lui fournit un tapis de nanotubes multi-parois de type « haute ». Ces résultats confirment que la croissance de mono ou multi-parois est aussi influencée par la taille des particules catalytiques, même si d'autres paramètres tels que la température, la concentration de la source carbonée et la réduction jouent également un rôle important.

### Taille des catalyseurs et morphologie.

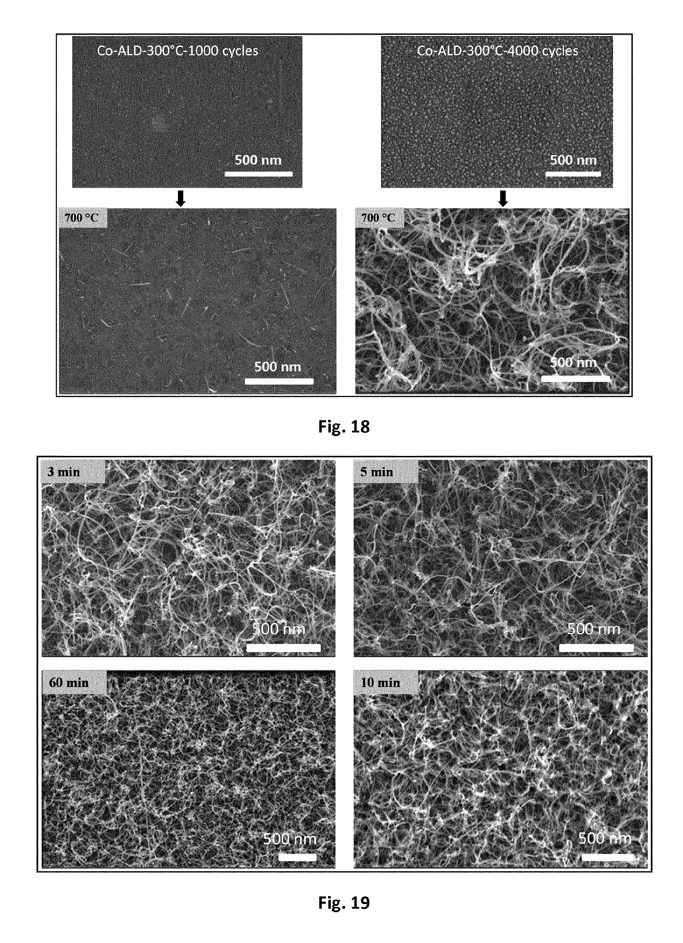

L'échantillon réalisé à 1000 cycles d'ALD donne les mêmes structures que celles observées sur les CVD à 700°C, des nanotubes mono ou doubles parois, ce qui corrèle bien l'influence de la taille des particules qui est environ 4 à 8 nm de diamètre moyen. Par ailleurs l'échantillon à 4000 cycles donne un tapis de tubes multi-parois comme observé à la figure 18.

### Temps de croissance.

La figure 19 montre qu'après 3 minutes de croissance (à paramètre constant), un tapis de nanotubes se forme déjà. Le tapis devient de plus en plus touffu avec l'augmentation du temps de croissance.

### Temps de réduction.

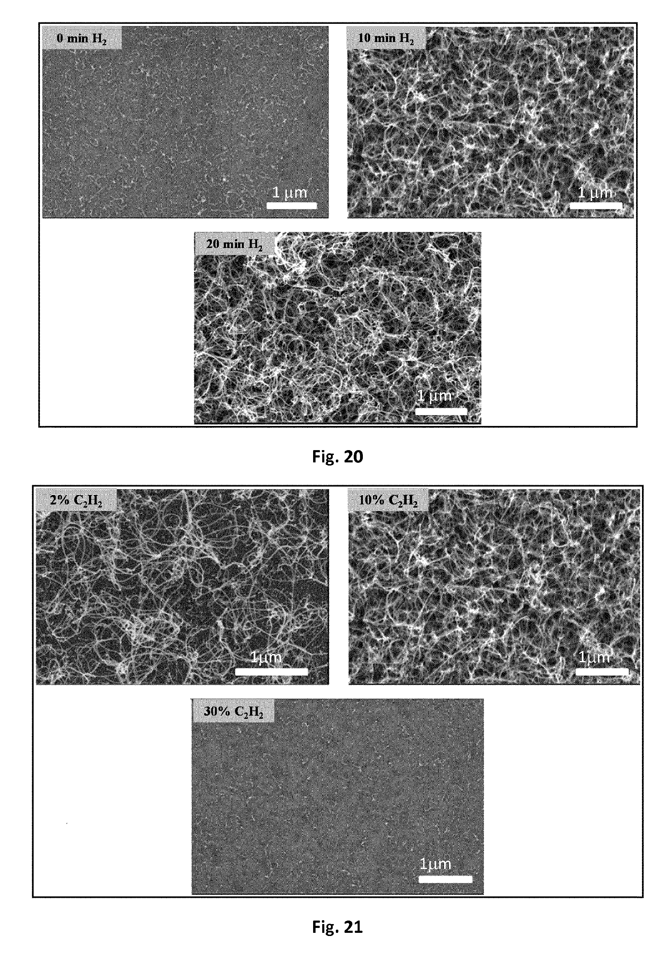

Le temps de réduction à l'hydrogène précédent l'étape de croissance a été investigué ici en gardant tous les paramètres constants. La figure 20 montre les images MEB de nanotubes synthétisés à des temps de réduction de 0, 10 et 20 minutes. Sans étape de réduction, une faible densité de nanotubes à la surface de l'échantillon est remarquée. Par contre pour 10 et 20 minutes, un tapis de nanotubes multi-parois est généré. Le rôle de la réduction à l'hydrogène est de nettoyer la surface des particules et de réduire les particules oxydées. En l'absence d'hydrogène, les particules oxydées et celles contaminées à la surface ne sont pas activés, ce qui conduit à une très faible densité de nanotubes.

### Concentration en acétylène.

La figure 21 montre les images MEB de nanotubes synthétisés à différentes concentrations d'acétylène en gardant les mêmes conditions que précédemment. Une concentration de 2%, 10% et 30% d'acétylène dans de l'azote a été utilisé, et il a été observé que cette concentration influence de manière significative la densité superficielle des nanotubes. A 2%, le procédé fournit une densité beaucoup plus faible qu'à 10%. Dans ces conditions, il n'y a pas suffisamment d'atomes de carbone pour réagir avec les particules. Il a été montré par ailleurs qu'à faible concentration du précurseur, le taux de carbone disponible réagissant avec les particules catalytiques est faible conduisant à une faible croissance. Par ailleurs à 30%, une faible densité de nanotubes est également obtenue: à forte concentration d'acétylène, la concentration d'atomes de carbone disponible devient très élevée, le taux de dissolution devient élevé par rapport au taux de précipitation et au taux de diffusion. Ceci entraine une accumulation de carbone à la surface de la particule et accélère sa sursaturation et sa perte d'activité de catalyse, ce qui conduit à une faible densité de nanotubes.

Les particules de carbure de cobalt ont été déposées sur des diatomées par ALD en configuration lit-fluidisé interne. Le précurseur utilisé est l'acétylacétonate de cobalt, et l'alcool réducteur est l'éthanol.

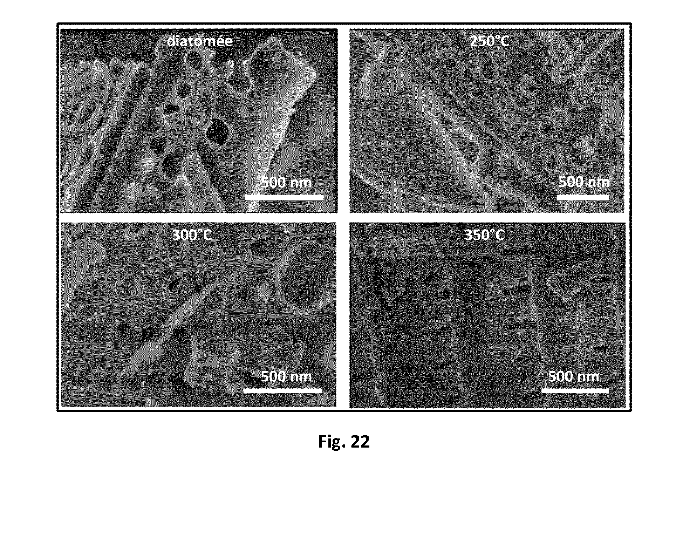

La figure 22 montre les images MEB de dépôts réalisés à 250, 300 et 350°C. Le temps d'exposition des précurseurs (acétylacétonate de cobalt et éthanol) était de 20s chacun ainsi que le temps de purge, le nombre de cycles était de 115. Aucun dépôt n'a été observé à 250°C, ce n'est qu'à partir de 300°C que la croissance de nanoparticules de carbure de cobalt sur la surface des diatomées est observée. Lors d'une croissance par ALD, l'énergie d'activation doit être suffisante pour permettre la croissance des premières couches atomiques. Le rôle de la température est ainsi de permettre l'activation de l'adsorption des précurseurs à la surface du substrat et la réaction entre les deux précurseurs. De plus, la hausse de la température favorise la migration de surface des atomes de cobalt et conduit à la formation de films ou de nanoparticules.

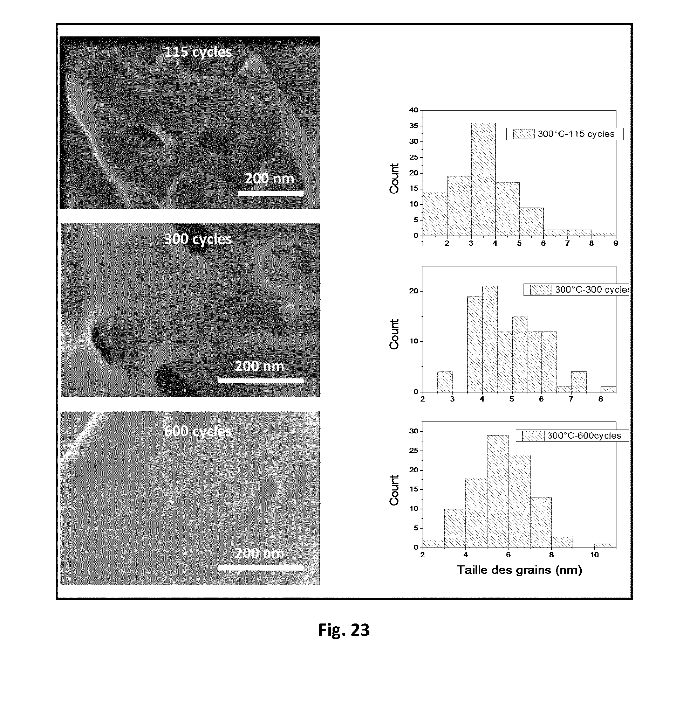

La morphologie des dépôts réalisés à 300°C en variant le nombre de cycles est illustrée à la figure 23. A 115 cycles, des particules moins denses et bien dispersées sont observée. La figure 23 reporte également la distribution de la taille des particules en fonction du nombre de cycles obtenue après extraction et traitement des images MEB par le logiciel Gwyddion. De 115 à 600 cycles d'ALD, il y a une légère augmentation de la taille moyenne des particules. Ceci est conforme avec les résultats rapportés dans la littérature qui montrent que dans les procédés ALD, la taille des particules augmente avec le nombre de cycle et par conséquent l'épaisseur des films.

La taille et la densité des particules catalytiques seront des paramètres qui influent beaucoup sur les dimensions et la densité des nanotubes de carbone. Ces deux caractéristiques du catalyseur peuvent être contrôlées à partir des paramètres du procédé ALD.

### Croissance de nanotube de carbone.

### Influence de la température de croissance.

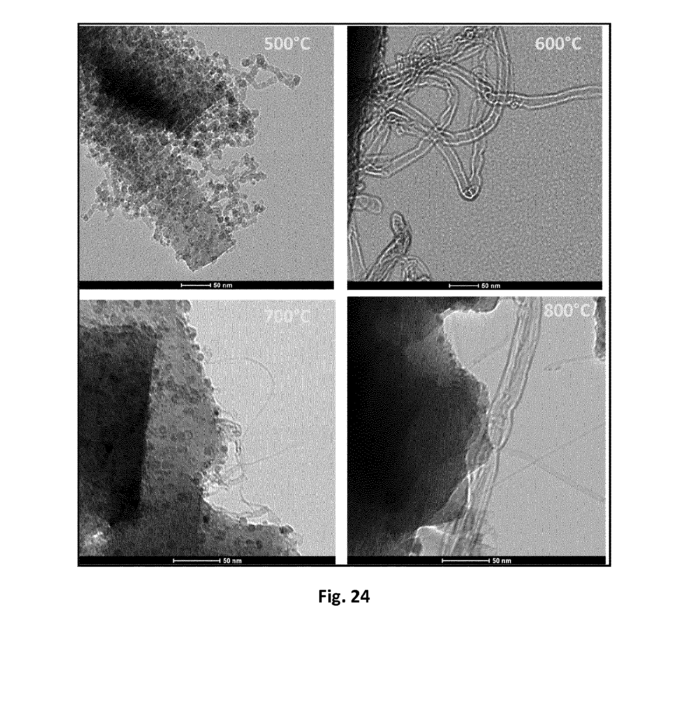

La figure 24 montre les images MET des tubes formés à différentes températures. A 500°C, les images montrent des structures courtes et tortueuses. A 600°C, l'échantillon est essentiellement constitué de nanotubes multi-parois avec de nombreux défauts induisant des coudes importants. A 700°C, un mélange de nanotubes mono-paroide petit diamètre et de multi-parois est observé. L'échantillon synthétisé à 800°C montre aussi des nanotubes mono-paroi et multi-parois de plus gros diamètre comparés à ceux de l'échantillon à 700°C.

### Influence du temps de croissance.

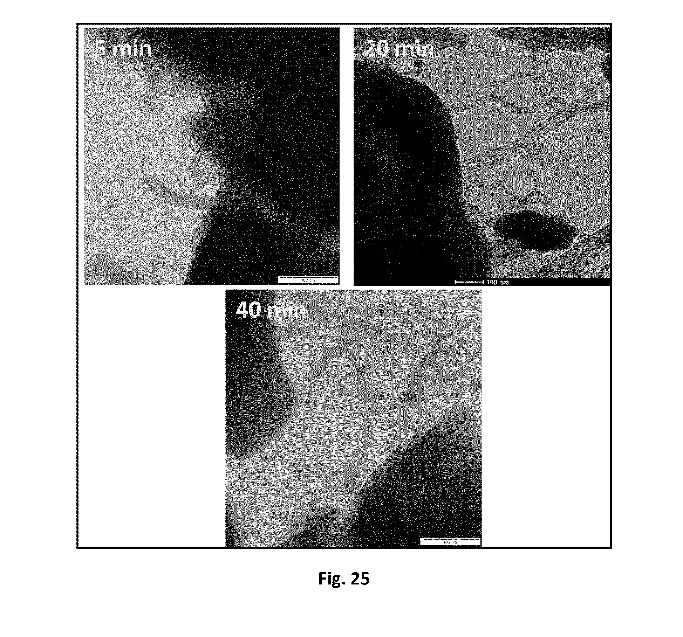

L'influence du temps de croissance a été étudiée à la température de 600°C, avec un temps de réduction de 20 minutes sou hydrogène, une croissance à l'aide d'un mélange 20% d'hydrogène dans du N₂ et 20% d'acétylène dans du N₂. La figure 25 montre les clichés MET de la morphologie des nanotubes à 5, 20 et 40 minutes de croissance. A 5 minutes de croissance, les tubes sont relativement courts comparés à ceux synthétisés à 20 minutes et à 40 minutes. Le nombre de nanotubes semble être plus important à 40 min de croissance mais cela ne confirme pas que les diatomées sont des structures en 3D et que les clichés TEM ne sont qu'une projection en 2D. Il a été démontré par plusieurs auteurs que la densité et la longueur des nanotubes augmentent avec l'augmentation du temps de croissance.

A partir des images MET, il est possible de constater que la majorité des nanotubes présents sont des MWNTs.

### Influence de la concentration d'acétylène.

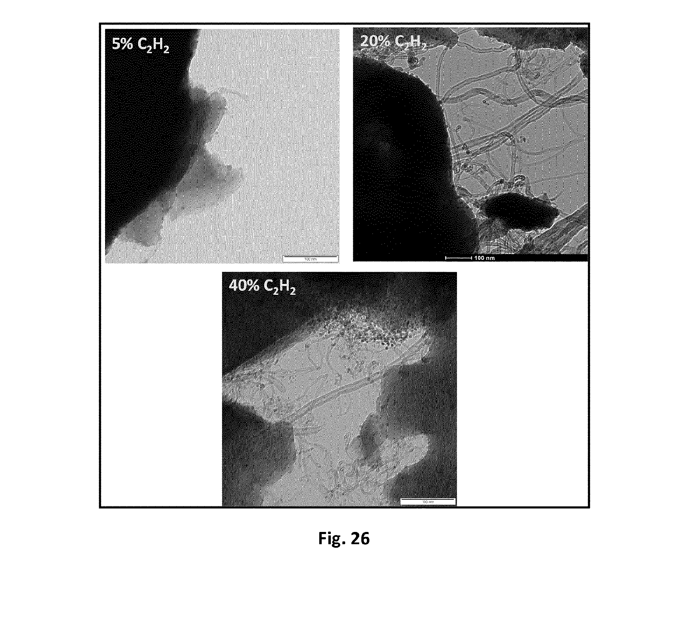

Trois concentrations d'acétylène (5, 20 et 40%) dans du N₂. La figure 26 montre les images MET de la morphologie des nanotubes en fonction de cette concentration. A 5% d'acétylène, un très faible taux de croissance est remarqué et il y a très peu de nanotubes. Des tubes MWNT sur les échantillons à 20 et 40% sont observés. L'augmentation de la concentration de la source carbonée favorise donc la croissance de MWNT.

### Influence du temps de réduction.

En gardant tous les paramètres constants, la température à 600°C, le temps de croissance à 20 minutes, la concentration d'acétylène à 20% molaire dans du N₂, le temps de réduction à l'hydrogène est varié à 0, 5 et 20 minutes pour étudier son influence sur la morphologie des nanotubes.

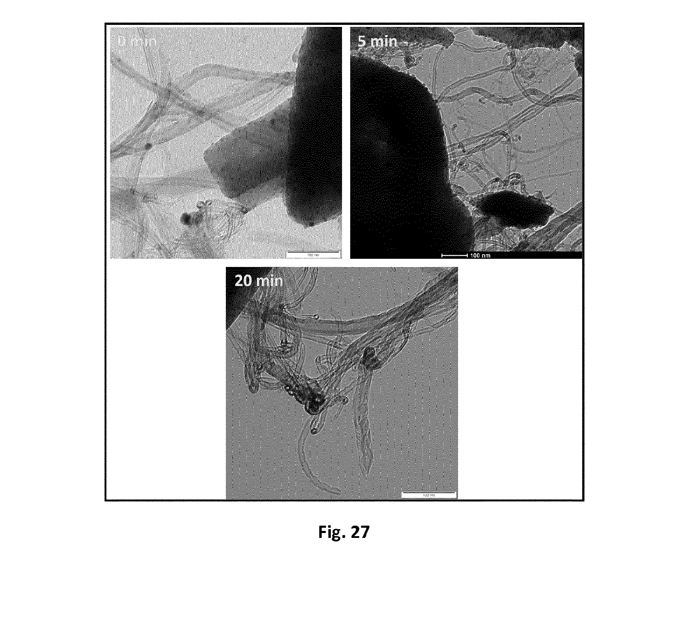

Les images TEM présentées à la figure 27 montre des MWNTs. Des points noirs sur les CNTs sans réduction hydrogène sont observés. Il s'agit certainement de particules métalliques. A 20 minutes les nanotubes ont peu de défauts et semblent être moins pollués par ces particules.

### Croissance de nanotubes de carbone sur lit-fluidisé externe (monoétape).

Dans la partie précédente, il a été démontré l'influence des paramètres de croissance sur la morphologie des nanotubes mais ceci a été fait sur de petites quantités de poudres de diatomées (quelques mg). Il est ainsi impossible pour des raisons liées à la limitation de la machine d'effectuer des dépôts ALD de nanoparticules sur une grande quantité de poudres (5g). Un système de lit fluidisé externe a été mis en place pour déposer les particules de cobalt par imprégnation en phase vapeur suivi du procédé de croissance de nanotubes sur 5g de poudre de diatomées sans remettre à l'air le système, évitant ainsi tous risques de contamination par des particules non-désirées, comme par exemple la poussière. Ce procédé a été nommé synthèse mono-étape et correspond également à un procédé de synthèse monotope.

Le Co(acac)₂ est chauffé à 170°C (température d'évaporation), puis un flux d'azote de 200 sccm est introduit pour transporter la vapeur de Co(acac) sur les particules de diatomées mises en suspension (fluidisation) pendant 10 minutes. Ensuite, l'étape de réduction est réalisée en introduisant de l'hydrogène dilué à 20% dans de l'azote à 600°C pendant 20 minutes. Ensuite, l'acétylène, dilué lui aussi à 20% dans de l'azote, est introduit pendant 40 minutes.

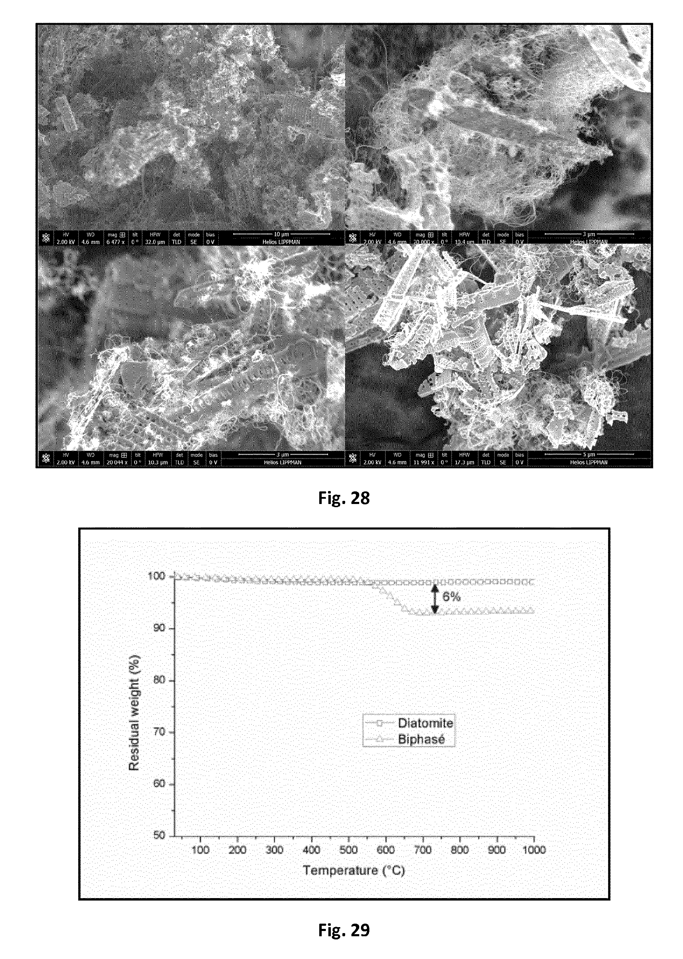

La figure 28 montre des images MEB de CNTs synthétisés sur des diatomées avec les paramètres sélectionnés précédemment. Une forte densité de CNTs sur certaines diatomées et une faible densité sur d'autres est remarquée. Le taux de couverture n'est pas égal à 100%. Certaines diatomées n'étaient peut-être pas suffisamment exposées aux gaz précurseurs.

La figure 29 montre l'analyse thermogravimétrique de l'échantillon présenté à la figure 28. La perte de masse a été mesurée dans un appareil NETZSCH-STA 409 PC, avec un flux d'air de 100 cm³.min⁻¹ dans un creuset en aluminium contenant 20-25 mg de l'échantillon. Les mesures ont été faites dans des conditions dynamiques avec une rampe de température de 10°C.min⁻¹.

A partir de 550°C, les nanotubes (et probablement le dépôt de résidus de carbone) sont complètement oxydés, ce qui permet d'approximer le taux de couverture à 6% en masse par rapport aux diatomées.

Les matériaux biphasiques à base de silice (diatomées) et de nanotubes de carbones conforme à la présente invention sont notamment utilisés comme agent de renforcement dans des matériaux composites à base de polymères, plus particulièrement à base d'élastomères.

Ces agents de renforcement présentent des propriétés remarquables, dont notamment l'augmentation de la surface spécifique de matériau à base de silice dû à l'introduction de nanotube de carbone, l'apport de propriétés électriques et/ou thermiques aux matériaux à base de silice.

## Revendications

1. Procédé de synthèse d'un matériau biphasé, ledit matériau biphasé comprenant au moins un substrat mésoporeux entouré de nanotubes de carbone, ledit procédé comprenant les étapes suivantes :
a. provision d'un catalyseur sur ledit au moins un substrat mésoporeux, ledit catalyseur étant configuré pour favoriser la croissance desdits nanotubes de carbone;
b. effectuer la croissance des nanotubes de carbone;
**caractérisé en ce que**
les deux étapes (a) et (b) sont effectuées en une synthèse monotope.

2. Procédé selon la revendication 1, caractérisé en ce l'étape (a) est effectuée par imprégnation du catalyseur en phase vapeur, par dépôt chimique en phase vapeur ou par dépôt de couches atomique et/ou de particules atomiques, de préférence par imprégnation du catalyseur en phase vapeur.

3. Procédé selon l'une quelconque des revendications 1-2, **caractérisé en ce que** ledit catalyseur est une nanoparticule métallique fournie dans une phase gazeuse.

4. Procédé selon l'une quelconque des revendications 1 à 3, **caractérisé en ce que** ledit catalyseur est un dérivé de nickel, de préférence de Ni(acac)₂, ou un dérivé de cobalt, de préférence Co(acac)₂.

5. Procédé selon l'une quelconque des revendications 1 à 4, **caractérisé en ce que** ledit catalyseur est réduit par un dérivé d'alcool ou par de l'hydrogène gazeux.

6. Procédé selon la revendication 5, **caractérisé en ce que** ledit dérivé d'alcool est un alcool primaire, de préférence le méthanol, l'éthanol et/ou propanol.

7. Procédé selon l'une quelconque des revendications 5-6, **caractérisé en ce que** ledit catalyseur et ledit dérivé d'alcool sont appliqués simultanément lorsque ladite étape de provision d'un catalyseur sur ledit au moins un substrat mésoporeux est réalisée par dépôt chimique en phase vapeur.

8. Procédé selon l'une quelconque des revendications 5-6, **caractérisé en ce que** ledit dérivé d'alcool est appliqué une fois que ledit au moins un catalyseur est déposé sur ledit au moins un substrat mésoporeux lorsque ladite étape de provision d'un catalyseur sur ledit au moins un substrat mésoporeux est réalisée par dépôt de couche atomique.

9. Procédé selon la revendication 5, **caractérisé en ce que** ledit hydrogène gazeux est mélangé avec de l'azote gazeux.

10. Procédé selon la revendication 9, **caractérisé en ce que** ledit mélange entre ledit hydrogène gazeux et ledit azote gazeux comprend une portion d'hydrogène gazeux par rapport à l'azote gazeux qui est comprise entre 2% et 30%.

11. Procédé selon l'une quelconque des revendications 5, 9 ou 10, **caractérisé en ce que** l'étape de réduction du catalyseur par l'hydrogène gazeux est effectuée pendant une durée comprise entre 2 minutes et 30 minutes, de préférence entre 5 minutes et 20 minutes, plus préférentiellement entre 10 minutes et 20 minutes, encore plus préférentiellement pendant une durée de 20 minutes.

12. Procédé selon l'une quelconque des revendications 1 à 11, **caractérisé en ce que** ledit au moins un substrat mésoporeux est composé d'un substrat mésoporeux de porosité non-organisée, préférentiellement d'un dérivé de silice de porosité non-organisée, plus préférentiellement de silice de diatomées, encore plus préférentiellement de diatomites.

13. Procédé selon la revendication 12, **caractérisé en ce que** ledit au moins un dérivé de la silice de porosité non-organisée est thermiquement oxydé à 1100°C pour fournir une couche de dioxyde de silicium de 50 nm d'épaisseur, avant ladite étape de provision d'un catalyseur sur ledit au moins un substrat mésoporeux.

14. Procédé selon l'une quelconque des revendications 4-13, **caractérisé en ce que** le Ni(acac)₂ est sublimé à une température comprise entre 150°C et 190°C, préférentiellement à 180°C.

15. Procédé selon l'une quelconque des revendications 4-13, **caractérisé en ce que** le Co(acac)₂ est sublimé à un température comprise entre 150°C et 190°C, préférentiellement à 180°C.

16. Procédé selon l'une quelconque des revendications 1 à 15, **caractérisé en ce que** ladite synthèse monotope est effectuée dans un réacteur à lit fluidisé.

17. Procédé selon l'une quelconque des revendications 1 à 16, **caractérisé en ce que** ladite étape de croissance de nanotubes de carbone comprend une étape de croissance avec de l'acétylène gazeux, ledit acétylène gazeux étant mélangé avec de l'azote gazeux ou un autre gaz inerte.

18. Procédé selon l'une quelconque des revendications 1 à 17, **caractérisé en ce que** ladite étape de croissance des nanotubes de carbone est effectuée à une pression comprise entre 2 mbar et 15 mbar, préférentiellement 13 mbar, et à une température comprise entre 500°C et 800°C, de préférence à une température de 500°C, 550°C, 600°C, 700°C ou 800°C, plus préférentiellement à une température de 600°C.

19. Procédé selon l'une quelconque des revendications 1 à 18, **caractérisé en ce que** ladite étape de croissance des nanotubes est effectuée pendant une durée comprise entre 3 minutes et 60 minutes, de préférence pendant un temps de 20 minutes, 40 minutes ou 60 minutes, plus préférentiellement pendant un temps de 40 minutes ou 60 minutes, encore plus préférentiellement pendant une période de 40 minutes.

20. Procédé selon l'une quelconque des revendications 17 à 19, **caractérisé en ce que** ledit mélange entre l'acétylène gazeux et ledit azote gazeux comprend une portion d'acétylène gazeux par rapport à l'azote gazeux qui est comprise entre 2% et 30%, de préférence qui est de 10% ou 20%, plus préférentiellement qui est de 20%.

21. Matériau biphasé obtenu par le procédé conformément à l'une quelconque des revendications 1 à 20, **caractérisé en ce que** ledit matériau biphasé est un agent de renforcement d'un matériau composite, préférentiellement d'un matériau composite à base de polymères.
